(19) Europäisches Patentamt
European Patent Office
Office européen des brevets

(11) EP 4 641 267 A1

(12) # EUROPEAN PATENT APPLICATION

published in accordance with Art. 153(4) EPC

(43) Date of publication:
**29.10.2025 Bulletin 2025/44**

(21) Application number: **23907627.6**

(22) Date of filing: **15.12.2023**

(51) International Patent Classification (IPC):
***G02B 5/30*** *(2006.01)* ***H10K 59/50*** *(2023.01)*
***G02F 1/13363*** *(2006.01)*

(52) Cooperative Patent Classification (CPC):
**G02B 5/30; G02F 1/13363; H10K 59/00; H10K 59/50**

(86) International application number:
**PCT/KR2023/020800**

(87) International publication number:
**WO 2024/136342 (27.06.2024 Gazette 2024/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **19.12.2022 KR 20220177943**

(71) Applicant: **SAMSUNG SDI CO., LTD.**
**Yongin-si, Gyeonggi-do 17084 (KR)**

(72) Inventors:
- **KO, Mun Bo**
  **Suwon-si Gyeonggi-do 16678 (KR)**
- **KIM, Bong Choon**
  **Suwon-si Gyeonggi-do 16678 (KR)**
- **SHIN, Kwang Ho**
  **SHIN Gyeonggi-do 16678 (KR)**

(74) Representative: **Michalski Hüttermann & Partner Patentanwälte mbB**
**Kaistraße 16A**
**40221 Düsseldorf (DE)**

(54) **POLARIZING PLATE AND OPTICAL DISPLAY DEVICE**

(57) A polarizing plate and an optical display device comprising same are provided, the polarizing plate comprising: a polarizer; and a phase difference layer laminated on the lower surface of the polarizer, wherein in the phase difference layer, the maximum value of the ratio expressed by formula 1 is 1.1 to 1.8 and the minimum value is 0.3 to 0.7. [Formula 1] Ratio B/A (A is the front surface phase difference (unit: nm) of the phase difference layer at wavelength of 550 nm, and B is an inclined phase difference (unit: nm) measured at wavelength of 550 nm with rotation of the phase difference layer by +60° or - 60° about a fast axis of the phase difference layer as the rotational axis.

【FIG. 1】

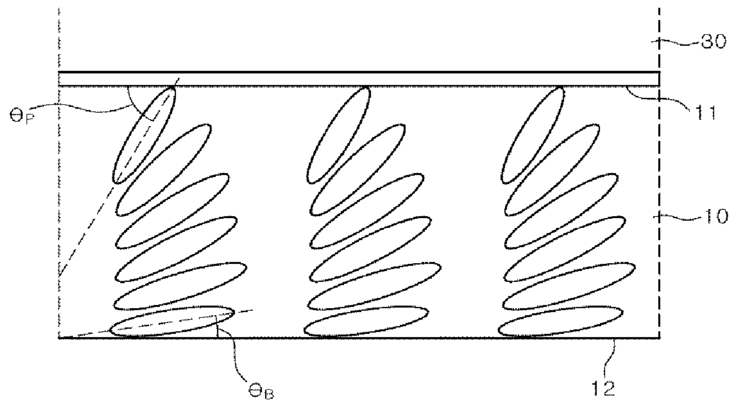




Processed by Luminess, 75001 PARIS (FR)

## Description

[Technical Field]

The present invention relates to a polarizing plate and an optical display apparatus including the same.

[Background Art]

An organic light emitting diode display may be provided with a polarizing plate. The polarizing plate can realize an antireflection function through reduction in reflectivity with respect to external light. It is desirable that the polarizing plate improve screen quality through improvement in black visibility at a front side.

The polarizing plate may include a polarizer and a retardation layer. In general, the retardation layer may be a double-sheet type retardation layer including a half wave plate (HWP) layer and a quarter wave plate (QWP) layer. It is desirable to improve processability while achieving remarkable reduction in reflectivity at front and lateral sides using a single-sheet type retardation layer instead of the double-sheet type retardation layer in the art.

The background technique of the present invention is disclosed in Korean Patent Laid-open Publication No. 10-2013-0103595 and the like.

[Disclosure]

[Technical Problem]

It is one object of the present invention to provide a polarizing plate that secures screen uniformity between a front side and a lateral side thereof through remarkable reduction in reflectivity at the front and lateral sides to reduce difference in reflectivity between the front side and the lateral side.

It is another object of the present invention to provide a polarizing plate that includes a single sheet type liquid crystal retardation layer while securing the above effects.

It is a further object of the present invention to provide a polarizing plate that includes a single sheet O-plate type liquid crystal retardation layer while securing the above effects.

It is yet another object of the present invention to provide a polarizing plate that can achieve reduction in thickness, simplification of a manufacturing process, and economic feasibility.

[Technical Solution]

One aspect of the present invention relates to a polarizing plate.

1. The polarizing plate includes: a polarizer; and a retardation layer stacked on a lower surface of the polarizer, wherein the retardation layer has a maximum ratio of 1.1 to 1.8 and a minimum ratio of 0.3 to 0.7, as calculated according to Equation 1:

[Equation 1]

$$\text{Ratio} = B/A,$$

(in the Equation 1,

A is a front retardation of the retardation layer (unit: nm) at a wavelength of 550 nm; and
B is an oblique retardation of the retardation layer (unit: nm), as measured at a wavelength of 550 nm with the retardation layer rotated at an angle of +60° or -60° about a fast axis of the retardation layer as a rotational axis).

2. In 1, the retardation layer may have an A value of 110 nm to 170 nm in Equation 1.
3. In 1 to 2, the retardation layer may have a maximum B value of 120 nm to 310 nm and a minimum B value of 20 nm to 120 nm in Equation 1.
4. In 1 to 3, the retardation layer may have a difference of 45 nm or more between the maximum oblique retardation and the minimum oblique retardation, as measured at a wavelength of 550 nm with the retardation layer rotated at an angle of +60° or -60° about the fast axis of the retardation layer as the rotational axis.
5. In 1 to 4, the retardation layer may have an oblique retardation of 130 nm to 240 nm, as measured at a wavelength of

550 nm with the retardation layer rotated at an angle of +60° or -60° about a slow axis of the retardation layer as the rotational axis.

6. In 1 to 5, the retardation layer may have negative wavelength dispersion.

7. In 1 to 6, the retardation layer may have an asymmetrical relative value in a graph where the x-axis denotes a rotational angle (°) of a retardation meter and the Y-axis denotes a relative value of oblique retardation (nm) to front retardation (nm) (oblique retardation/front retardation), the oblique retardation being measured with the fast axis of the retardation layer set as the rotational axis.

8. In 1 to 7, the retardation layer may have a symmetrical relative value in a graph where the x-axis denotes a rotational angle (°) of a retardation meter and the Y-axis denotes a relative value of oblique retardation (nm) to front retardation (nm) (oblique retardation/front retardation), the oblique retardation being measured with a slow axis of the retardation layer set as a rotational axis.

9. In 1 to 8, a slow axis of the retardation layer may be tilted at an angle of 40° to 50° with respect to a light transmission axis of the polarizer, assuming that the light transmission axis of the polarizer is set to 0°.

10. In 1 to 9, the retardation layer may include an O-plate type liquid crystal retardation layer.

11. In 10, assuming that one surface of the O-plate type liquid crystal retardation layer in a thickness direction thereof is a TOP surface and the other surface thereof opposite the top surface is a BOTTOM surface, the O-plate type liquid crystal retardation layer may have a greater liquid crystal tilt angle on the TOP surface than on the BOTTOM surface.

12. In 11, the O-plate type liquid crystal retardation layer may have a liquid crystal tilt angle of 30° to 90° on the TOP surface and a liquid crystal tilt angle of 0° to 10° on the BOTTOM surface.

13. In 11 to 12, the TOP surface may be closer to the polarizer than the BOTTOM surface.

14. In 11 to 13, an absolute difference between the liquid crystal tilt angle on the TOP surface and the liquid crystal tilt angle on the BOTTOM surface may range from 30° to 90°.

15. In 10 to 14, the O-plate type liquid crystal retardation layer may be a nematic liquid crystal layer.

16. In 10 to 15, the retardation layer may comprise the O-plate type liquid crystal retardation layer alone.

17. In 10 to 16, the polarizing plate may further include a first protective layer on a lower surface of the polarizer.

18. In 17, the first protective layer may have a front retardation of 10 nm or less at a wavelength of 550 nm.

19. In 1 to 18, the polarizing plate may further include at least one of a second protective layer on an upper surface of the polarizer and a third protective layer on the lower surface of the polarizer.

Another aspect of the present invention relates to an optical display apparatus.

The optical display apparatus includes the polarizing plate according to the present invention.

[Advantageous Effects]

The present invention provides a polarizing plate that secures screen uniformity between a front side and a lateral side through remarkable reduction in reflectivity at the front side and the lateral side to reduce difference in reflectivity between the front side and the lateral side.

The present invention provides a polarizing plate that includes a single sheet type liquid crystal retardation layer while securing the above effects.

The present invention provides a polarizing plate that includes a single sheet O-plate type liquid crystal retardation layer while securing the above effects.

The present invention provides a polarizing plate that can achieve reduction in thickness, simplification of a manufacturing process, and economic feasibility.

[Description of Drawings]

FIG. 1 is an exploded view of a retardation layer and a polarizer according to one embodiment of the present invention.

FIG. 2 is a conceptual view of a liquid crystal tilt angle.

FIG. 3 is a graph depicting retardation values according to a rotational angle of the retardation layer about a fast axis or a slow axis thereof as a rotational axis, where the x-axis denotes a rotational angle (°) of a retardation meter and the Y-axis denotes a relative value of oblique retardation (nm) to front retardation (nm) (oblique retardation/front retardation), and where a solid line indicates a relative value of the retardation layer rotated about the fast axis as the rotational axis and a dotted line indicates a relative value of the retardation layer rotated about the slow axis as the rotational axis.

FIG. 4 to FIG. 9 are sectional views of a polarizing plate according to one embodiment of the present invention.

[Best Mode]

Hereinafter, embodiments of the present invention will be described in detail with reference to the accompanying drawings such that the present invention can be easily implemented by those skilled in the art. It should be understood that the present invention may be embodied in different ways and is not limited to the following embodiments.
The terminology used herein is for the purpose of describing exemplary embodiments and is not intended to limit the scope of the invention. Herein, the singular forms "a," "an," and "the" are intended to include the plural forms as well, unless the context clearly indicates otherwise.
In the drawings, portions irrelevant to the description will be omitted for clarity. Like components will be denoted by like reference numerals throughout the specification. Although lengths, thicknesses or widths of various components may be exaggerated in the drawings for description of the invention, the present invention is not limited thereto.
Herein, spatially relative terms such as "upper" and "lower" are defined with reference to the accompanying drawings. Thus, it will be understood that "upper surface" can be used interchangeably with "lower surface" and vice versa.
Herein, "front in-plane retardation (Re)", "degree of biaxiality (NZ)," and "out-of-plane retardation (Rth)" of an optical device are represented by Equations A, B and C, respectively:

[Equation A]

$$Re = (nx - ny) \times d$$

[Equation B]

$$NZ = (nx - nz)/(nx - ny)$$

[Equation C]

$$Rth = ((nx + ny)/2 - nz) \times d$$

(in the Equations A to C, nx, ny, and nz are indexes of refraction of the optical device in the slow axis direction, the fast axis direction and the thickness direction thereof at a measurement wavelength, respectively, and d denotes the thickness of the optical device (unit: nm)).
The optical device may be a retardation layer, a protective layer or a laminate thereof. Unless specified otherwise, retardation, the degree of biaxiality, and out-of-plane retardation refer to values measured by transmitting light through the optical device in the normal direction to an in-plane direction of the optical device.
As used herein, an axis having the highest index of refraction in the in-plane direction is defined as the "slow axis" and an axis having the lowest index of refraction in the in-plane direction is defined as the "fast axis". In one embodiment, the slow axis and the fast axis may be substantially orthogonal to each other, but are not limited thereto.
As used herein to represent a specific numerical range, "X to Y" means "greater than or equal to X and less than or equal to Y (X≤ and ≤Y)."
The polarizing plate according to the present invention includes a polarizer; and a retardation layer stacked on a lower surface of the polarizer. When the polarizing plate is applied to an optical display apparatus, the retardation layer is disposed between the polarizer and a panel for the optical display apparatus. That is, the retardation layer may be disposed on a light incidence surface of the polarizer in a light emission direction of a light emitting diode including an organic light emitting diode (OLED) and the like. The optical display apparatus may be a light emitting diode display including OLEDs and the like.
The retardation layer may have a maximum ratio of 1.1 to 1.8 and a minimum ratio of 0.3 to 0.7, as calculated according to Equation 1:

[Equation 1]

$$Ratio = B / A,$$

(in the Equation 1,

A is a front retardation of the retardation layer (unit: nm) at a wavelength of 550 nm; and
B is an oblique retardation of the retardation layer (unit: nm), as measured at a wavelength of 550 nm with the

retardation layer rotated at an angle of +60° or -60° about a fast axis of the retardation layer as a rotational axis.

The ratio of Equation 1 is devised to determine conditions under which the retardation layer has significantly improved effects in reduction of reflectivity at front and lateral sides when the polarizing plate is applied to an optical display apparatus. Accordingly, the polarizing plate may be used as an antireflection polarizing plate in light emitting device displays, such as an organic light emitting diode display, an inorganic light emitting device display, and an organic-inorganic light emitting diode display.

As described below, it is possible to determine, based on the ratio of Equation 1, whether the retardation layer can provide remarkable effects in reduction of reflectivity at the front side and the lateral side of the polarizing plate when the retardation layer is a single-sheet type (single layer) O-plate type liquid crystal retardation layer. In addition, the ratio of Equation 1 is devised to determine conditions under which the retardation layer reduces reflectivity at the front side and the lateral side of the polarizing plate while minimizing difference in reflectivity between the front side and the lateral side when the retardation layer exhibits negative wavelength dispersion.

Front in-plane retardation of the retardation layer is a single value. On the contrary, the retardation layer has the maximum oblique retardation and the minimum oblique retardation, as measured with the retardation layer rotated at an angle of +60° or - 60° about the fast axis of the retardation layer as the rotational axis. The ratio of Equation 1 is obtained based on the front in-plane retardation value of the retardation layer and the oblique retardation value of the retardation layer.

When the maximum ratio of Equation 1 is in the range of 1.1 to 1.8 and the minimum ratio of Equation 1 is in the range of 0.3 to 0.7, the polarizing plate can secure remarkable reduction in reflectivity at the front and lateral sides thereof while providing better screen uniformity between a front side and a lateral side of a display apparatus through reduction in reflectivity difference therebetween. For example, the maximum ratio may be 1.1, 1.15, 1.2, 1.25, 1.3, 1.35, 1.4, 1.45, 1.5, 1.55, 1.6, 1.65, 1.7, 1.75, 1.8, 1.2 to 1.75, 1.2 to 1.7, or 1.3 to 1.6. For example, the minimum value may be 0.3, 0.35, 0.4, 0.45, 0.5, 0.55, 0.6, 0.65, 0.7, 0.3 to 0.65, 0.35 to 0.65, or 0.4 to 0.6.

As calculated according to Equation 1, the maximum ratio of 1.1 to 1.8 and the minimum ratio of 0.3 to 0.7 may be realized by adjusting a solvent volatilization rate (for example, air volume) and/or drying temperature on a coating layer formed of a composition for the O-plate type liquid crystal retardation layer, and/or an irradiation quantity of UV light during photo-curing of the coating layer, in manufacture of the retardation layer, particularly the O-plate type liquid crystal retardation layer. This will be described in detail below.

Hereinafter, each component of the polarizing plate according to the present invention will be described in detail.

## Polarizer

The polarizer serves to convert natural light or polarized light into linearly polarized light through linear polarization in a certain direction. The polarizer may be fabricated from a polymer film mainly consisting of a polyvinyl alcohol resin. For example, the polarizer may be fabricated by dyeing the polymer film with iodine or dichroic dyes, followed by stretching the dyed film in a machine direction (MD) thereof, or may be fabricated by forming a polyene bond through dehydration of the polymer film using an acid catalyst and the like. In one embodiment, the polarizer may be fabricated through swelling, dyeing, stretching, and, optionally, color correction and/or crosslinking of a polyvinyl alcohol film.

The polarizer has a light absorption axis and a light transmission axis in an in-plane direction thereof, in which the light absorption axis corresponds to the machine direction (MD) thereof and the light transmission axis may correspond to the transverse direction (TD) thereof.

The polarizer may have a single light transmittance of 40% or more, for example, 40% to 47%, and a degree of polarization of 95% or more, for example, 95% to 99.9999%. Within this range, the polarizer can improve antireflection efficiency in combination with the retardation layer. Here, "light transmittance" and "degree of polarization" may be measured at a wavelength of 380 nm to 780 nm by a method known to those skilled in the art and may correspond to visibility in the corresponding wavelength range.

The polarizer may have a thickness of 2 $\mu$m to 30 $\mu$m, specifically 4 $\mu$m to 25 $\mu$m. Within this range, the polarizer can be applied to the polarizing plate.

The polarizer may be directly stacked on the retardation layer or the protective layer without an adhesive layer or a bonding layer, or via the adhesive layer or the bonding layer.

## Retardation layer

The retardation layer may have a maximum ratio of Equation 1 in the range of 1.1 to 1.8 and a minimum ratio of Equation 1 in the range of 0.3 to 0.7. Within this range, the polarizing plate can secure remarkable reduction in reflectivity at front and lateral sides thereof while providing good screen uniformity through reduction in reflectivity difference between the front side and the lateral side. In one embodiment, the retardation layer may have a maximum ratio of 1.2 to 1.75, 1.2 to

1.7, or 1.3 to 1.6, and a minimum ratio of 0.3 to 0.65, 0.35 to 0.65, or 0.4 to 0.6.

In one embodiment, the retardation layer may have a ratio of Equation 1 in the range of 0.3 to 1.8, for example, 0.3, 0.35, 0.4, 0.45, 0.5, 0.55, 0.6, 0.65, 0.7, 0.75, 0.8, 0.85, 0.9, 0.95, 1.0, 1.05, 1.1, 1.15, 1.2, 1.25, 1.3, 1.35, 1.4, 1.45, 1.5, 1.55, 1.6, 1.65, 1.7, 1.75, or 1.8.

In the ratio of Equation 1, A and B will be described in detail. A and B are measured at a wavelength of 550 nm using a retardation meter, for example, an AxoScan. The AxoScan is typically used by those skilled in the art in measurement of retardation.

A denotes a front in-plane retardation value of the retardation layer measured when light is incident on the polarizing plate in the normal direction to the in-plane direction of the retardation layer, with the retardation layer mounted on the retardation meter.

B may be obtained from retardation of the retardation layer, with the retardation layer mounted on the retardation meter and rotated at an angle of +60° or -60° about the fast axis of the retardation layer as the rotational axis. +60° is defined as the clockwise direction with respect to the rotational axis and -60° is defined as the counterclockwise direction with respect to the rotational axis, or vice versa.

In one embodiment, the retardation layer may have an A value of 110 nm to 170 nm in Equation 1, for example, 110 nm, 115 nm, 120 nm, 125 nm, 130 nm, 135 nm, 140 nm, 145 nm, 150 nm, 155 nm, 160 nm, 165 nm, 170 nm, 120 nm to 160 nm, or 130 nm to 150 nm. Within this range, the retardation layer can easily reach the above ranges of the maximum ratio and the minimum ratio of Equation 1 and can be easily formed.

In one embodiment, the retardation layer may have a maximum B value of 120 nm to 310 nm in Equation 1, for example, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 310 nm, 130 nm to 290 nm, or 140 nm to 270 nm, and a minimum B value of 30 nm to 120 nm in Equation 1, for example, 30 nm, 35 nm, 40 nm, 45 nm, 50 nm, 55 nm, 60 nm, 65 nm, 70 nm, 75 nm, 80 nm, 85 nm, 90 nm, 95 nm, 100 nm, 105 nm, 110 nm, 115 nm, 120 nm, 35 nm to 110 nm, or 40 nm to 100 nm. Within this range, the retardation layer can easily reach the above ranges of the maximum ratio and the minimum ratio of Equation 1 and can be easily formed.

In one embodiment, the retardation layer may have a difference of 45 nm or more between the maximum oblique retardation and the minimum oblique retardation thereof, for example, 45 nm to 250 nm, 45 nm, 50 nm, 55 nm, 60 nm, 65 nm, 70 nm, 75 nm, 80 nm, 85 nm, 90 nm, 95 nm, 100 nm, 105 nm, 110 nm, 115 nm, 120 nm, 125 nm, 130 nm, 135 nm, 140 nm, 145 nm, 150 nm, 155 nm, 160 nm, 165 nm, 170 nm, 175 nm, 180 nm, 185 nm, 190 nm, 195 nm, 200 nm, 205 nm, 210 nm, 215 nm, 220 nm, 225 nm, 230 nm, 235 nm, 240 nm, 245 nm, or 250 nm, as measured at a wavelength of 550 nm with the retardation layer rotated at an angle of +60° or -60° about the fast axis thereof as the rotational axis. Within this range, the effects of the present invention can be easily achieved.

The retardation layer may have an oblique retardation of 130 nm to 240 nm, for example, 130 nm, 135 nm, 140 nm, 145 nm, 150 nm, 155 nm, 160 nm, 165 nm, 170 nm, 175 nm, 180 nm, 185 nm, 190 nm, 195 nm, 200 nm, 205 nm, 210 nm, 215 nm, 220 nm, 225 nm, 230 nm, 235 nm, 240 nm, 140 nm to 220 nm, or 150 nm to 200 nm, as measured at a wavelength of 550 nm with the retardation layer rotated at an angle of +60° or -60° about the slow axis thereof as the rotational axis. Within this range, the effects of the present invention can be easily achieved.

The retardation layer may have negative wavelength dispersion. As a result, the polarizing plate can easily provide the effect of reducing reflectivity at front and laterals sides thereof. Here, the "negative wavelength dispersion" of the retardation layer means that the retardation layer satisfies relations: $Re(450)<Re(550)$ and $Re(550)<Re(650)$. Re(450), Re(550), and Re(650) denote front in-plane retardation values of the retardation layer at wavelengths of 450 nm, 550 nm, and 650 nm, respectively.

In one embodiment, the retardation layer may have an Re(450)/Re(550) value of less than 1, for example, 0.82 to less than 1, 0.82, 0.83, 0.84, 0.85, 0.86, 0.87, 0.88, 0.89, 0.9, 0.91, 0.92, 0.93, 0.94, 0.95, 0.96, 0.97, 0.98, or 0.99. In one embodiment, the retardation layer may have an Re(650)/Re(550) value of greater than 1, for example, greater than 1 to 1.18, 1.01, 1.02, 1.03, 1.04, 1.05, 1.06, 1.07, 1.08, 1.09, 1.10, 1.11, 1.12, 1.13, 1.14, 1.15, 1.16, 1.17, or 1.18. Within this range, the retardation layer can easily achieve wavelength dispersion.

In one embodiment, the retardation layer may have a front in-plane retardation of 90 nm to 170 nm, for example, 100 nm to 160 nm, at a wavelength of 450 nm, and may have a front in-plane retardation of 110 nm to 200 nm, for example, 120 nm to 190 nm, at a wavelength of 650 nm.

In one embodiment, the retardation layer may be a single sheet type retardation layer. Here, "single sheet type retardation layer" means that the retardation layer is composed of a single layer having the same composition rather than a laminate of two or more retardation layers having different front retardation values (which is formed through attachment or direct lamination). As such, even with the single sheet type retardation layer, which is stacked on the lower surface of the polarizer, for example, between the lower surface of the polarizer and an optical display panel and satisfies Equation 1, the polarizing plate according to the present invention provides good effects in reduction of reflectivity at front and lateral sides thereof and in reduction of reflectivity difference between the front side and the lateral side thereof, thereby achieving reduction in thickness thereof, simplification of a manufacturing process, and economic feasibility.

In one embodiment, the retardation layer may have a thickness of 1 μm to 10 μm, for example, 2 μm to 8 μm. Within this range, the polarizing plate can have a reduced thickness.

The retardation layer may be an O-plate type liquid crystal layer. The polarizing plate according to the present invention includes the O-plate type liquid crystal layer as the retardation layer, in which the maximum ratio and the minimum ratio of Equation 1 of the O-plate type liquid crystal layer are adjusted to provide the effects of reducing reflectivity at front and lateral sides and reflectivity difference therebetween.

Here, the O-plate type means that a liquid crystal compound is aligned such that a liquid crystal tilt angle of the liquid crystal compound is formed in an oblique direction in the thickness direction of the retardation layer and, assuming that one surface of the retardation layer in the thickness direction is a TOP surface and the other surface thereof opposite the top surface is a BOTTOM surface, the liquid crystal tilt angle gradually increases or decreases from the TOP surface to the BOTTOM surface. Here, the oblique direction means a direction substantially not parallel to the TOP surface or the BOTTOM surface of the retardation layer and/or a direction substantially not perpendicular thereto.

FIG. 1 is a sectional view of the O-plate type retardation layer, showing that a retardation layer 10 has liquid crystal tilt angles ($\theta_P$, $\theta_B$) gradually decreasing from the TOP surface 11 to the BOTTOM surface 12.

In one embodiment, the retardation layer may have a greater liquid crystal tilt angle on the TOP surface than on the BOTTOM surface, and may have a liquid crystal tilt angle of 30° to 90°, for example, 30°, 35°, 40°, 45°, 50°, 55°, 60°, 65°, 70°, 75°, 80°, 85°, 90°, or 40° to less than 90°, on the TOP surface thereof, and a liquid crystal tilt angle of 0° to 10°, for example, 0°, 1°, 2°, 3°, 4°, 5°, 6°, 7°, 8°, 9°, 10°, 0° to 5°, or greater than 0° to 5°, on the BOTTOM surface thereof.

In another embodiment, the retardation layer may have a smaller liquid crystal tilt angle on the TOP surface than on the BOTTOM surface, and may have a liquid crystal tilt angle of 0° to 10°, for example, 0°, 1°, 2°, 3°, 4°, 5°, 6°, 7°, 8°, 9°, 10°, 0° to 5°, or greater than 0° to 5°, on the TOP surface thereof, and a liquid crystal tilt angle of 0° to 10°, for example, 30° to 90°, for example, 30°, 35°, 40°, 45°, 50°, 55°, 60°, 65°, 70°, 75°, 80°, 85°, 90°, or 40° to less than 90°, on the BOTTOM surface thereof.

In one embodiment, the TOP surface of the retardation layer may be closer to the polarizer 30 than the BOTTOM surface thereof, as shown in FIG. 1. In the retardation layer, the retardation layer may have a greater liquid crystal tilt angle on the TOP surface than on the BOTTOM surface. As a result, the effects of the present invention can be more easily realized.

In one embodiment, an absolute difference between the liquid crystal tilt angle on the TOP surface and the liquid crystal tilt angle on the BOTTOM surface may range from 30° to 90°, for example, 30°, 35°, 40°, 45°, 50°, 55°, 60°, 65°, 70°, 75°, 80°, 85°, 90°, or 40° to 80°. Within this range, the effects of the invention can be more easily realized

Herein, the "liquid crystal tilt angle" may have substantially the same meaning as defined by those skilled in the art. For example, the liquid crystal tilt angle may be measured inside the retardation layer and refers to an oblique alignment angle of liquid crystals in the thickness direction of the retardation layer, which gradually varies from the TOP surface of the retardation layer to the BOTTOM surface thereof. When the oblique alignment angle is parallel to the TOP surface or the BOTTOM surface of the retardation layer, the liquid crystal tilt angle is defined as 0°.

The liquid crystal tilt angle may be represented by a positive (+) or negative (-) value depending on whether the liquid crystal tilt angle corresponds to a direction of the maximum refractive index of the liquid crystal compound with respect to one surface of a layer adjacent to the retardation layer. Here, the liquid crystal tilt angle will be described as a positive value (+) for convenience. Alternatively, the liquid crystal tilt angle may be a negative (-) value. For example, when the liquid crystal tilt angle is 60°, it means -60°.

Referring to FIG. 2, the liquid crystal tilt angle is defined as an angle of the direction of the maximum refractive index of the liquid crystal compound with respect to one surface of the retardation layer. As in θ1, when the angle of the direction of the maximum refractive index of the liquid crystal compound with respect to the one surface of the layer adjacent to the retardation layer corresponds to the counterclockwise direction, the angle is defined as a positive (+) value. As in θ2, when the angle of the direction of the maximum refractive index of the liquid crystal compound with respect to the one surface of the layer adjacent to the retardation layer corresponds to the clockwise direction, the angle is defined as a negative (-) value.

The liquid crystal tilt angle may be measured by a typical method known to those skilled in the art. For example, the liquid crystal tilt angle may be measured by a liquid crystal tilt angle meter, for example, an AxoScan or Kobra.

In one embodiment, the retardation layer may have an asymmetrical oblique retardation, as measured with the retardation layer mounted on the retardation meter and rotated at an angle of +60° or -60° about the fast axis of the retardation layer as a rotational axis. This structure can facilitate achievement of the effects of the present invention. This structure will be described with reference to FIG. 3.

FIG. 3 is a graph depicting tendency of a ratio of oblique retardation to front retardation of a retardation layer of a polarizing plate according to one embodiment of the invention, as measured with the retardation layer rotated at an angle of ±60°.

In FIG. 3, the x-axis denotes a rotational angle (°) of a retardation meter and the Y-axis denotes a relative value of oblique retardation (nm) to front retardation (nm) (oblique retardation/front retardation). In FIG. 3, a solid line indicates a

relative value of the retardation layer rotated about the fast axis of the retardation layer as the rotational axis and a dotted line indicates a relative value of the retardation layer rotated about the slow axis thereof as the rotational axis. FIG. 3 is obtained from measurement results with respect to retardation layers in examples described below.

Referring to FIG. 3, in the graph where the x-axis denotes the rotational angle (°) of the retardation meter and the Y-axis denotes the relative value of the oblique retardation (nm) to the front retardation (nm) (oblique retardation/front retardation), it can be seen that the retardation layer has an asymmetrical relative value when the relative value is measured while rotating the retardation layer about the fast axis thereof as the rotational axis, and a symmetrical relative value, when the relative value is measured while rotating the retardation layer about the slow axis thereof as the rotational axis.

FIG. 3 shows relative values at a wavelength of 550 nm but is not limited thereto.

In one embodiment, the retardation layer may be a liquid crystal layer or a non-liquid crystal layer. For example, the retardation layer may be a liquid crystal layer to provide the O-plate type liquid crystal retardation layer.

In one embodiment, the retardation layer may be formed of a composition comprising a liquid crystal compound. For example, the retardation layer may be formed of a composition capable of realizing nematic liquid crystals. The nematic liquid crystals allow the ratio of Equation 1 within a desired range of the present invention to be easily achieved by making oblique retardation of the retardation layer asymmetrical as shown in FIG. 3 when the retardation layer is rotated at +60° or -60° about the fast axis thereof as the rotational axis. Here, even with the composition capable of realizing the nematic liquid crystals, the retardation layer satisfying the ratio of Equation 1 according to the present invention may be realized by adjusting a solvent volatilization rate (for example, air volume) and/or drying temperature on a coating layer formed of the composition, and/or an irradiation quantity of UV light during photo-curing of the coating layer.

In one embodiment, the composition realizing the nematic liquid crystals may include a polymerizable compound.

The polymerizable compound may have at least one polymerizable crosslinking group. For example, the polymerizable crosslinking group may include an acrylate group, a methacrylate group, a vinyl group, a vinyl oxy group, an epoxy group, an oxetane group, a thiol group, a maleimide group, or derivatives thereof. Specifically, the polymerizable crosslinking group may include at least one selected from Formulas R-1 to R-15:

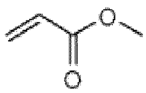
(R-1)

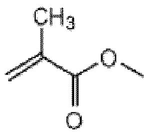
(R-2)

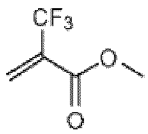
(R-3)

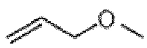
(R-4)

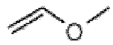
(R-5)

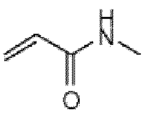
(R-6)

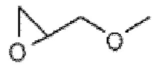
(R-7)

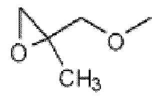
(R-8)

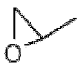
(R-9)

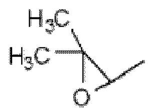
(R-10)

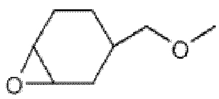
(R-11)

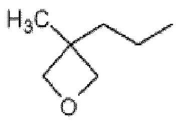
(R-12)

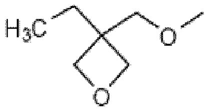
(R-13)

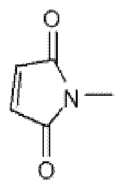
(R14)

HS—
(R-15)

The composition may further include a liquid crystal compound. Although the liquid crystal compound does not have a polymerizable crosslinking group, the liquid crystal compound facilitates formation of the retardation layer.

The composition may further include typical additives, for example, a photo initiator, a surface regulator, an antioxidant, and the like, which are used in realization of the liquid crystal layer. The composition may include a solvent to facilitate formation of a liquid crystal layer having a uniform surface

The slow axis of the retardation layer, for example, the slow axis of the O-plate type liquid crystal retardation layer is tilted at an angle of 40° to 50°, for example, 40°, 41°, 42°, 43°, 44°, 45°, 46°, 47°, 48°, 49°, 50°, or 43° to 47°, with respect to the light transmission axis of the polarizer, when the light transmission axis of the polarizer is set to 0°. Within this range, the effects

of the present invention can be more easily realized.

The retardation layer, for example, the O-plate type liquid crystal retardation layer, may be formed of a composition containing the composition comprising the liquid crystal compound described above. According to the present invention, in order to satisfy the minimum ratio of 1.1 to 1.8 and the minimum ratio of 0.3 to 0.7 as calculated according to Equation 1, the irradiation quantity of UV light, the drying temperature, the air volume and the like are adjusted in formation of the retardation layer. Here, it could be seen that the solvent volatilization rate could significantly affect the liquid crystal tilt angle on the TOP surface. It could be seen that the solvent volatilization rate and the liquid crystal tilt angle generally increased with increasing drying temperature and air volume. The liquid crystal tilt angle on the BOTTOM surface relates to anchoring energy and may be adjusted according to light alignment or rubbing conditions. In general, the liquid crystal tilt angle on the BOTTOM surface increases with increasing anchoring energy.

In one embodiment, the retardation layer may be composed of the O-plate type liquid crystal retardation layer alone. This means that only the O-plate type liquid crystal retardation layer having a front in-plane retardation of greater than 0 nm, for example, greater than 10 nm, at a wavelength of 550 nm is present as the retardation layer on the lower surface of the polarizer. Here, the O-plate type liquid crystal retardation layer may be directly stacked on the lower surface of the polarizer or may be stacked thereon via an adhesive layer or a bonding layer.

In another embodiment, the polarizing plate may further include a first protective layer on the lower surface of the polarizer.

In one embodiment, the polarizing plate may include the first protective layer and the O-plate type liquid crystal retardation layer sequentially stacked on the lower surface of the polarizer.

In another embodiment, the polarizing plate may include the O-plate type liquid crystal retardation layer and the first protective layer sequentially stacked on the lower surface of the polarizer.

The first protective layer may provide additional functions to the retardation layer and/or the polarizing plate. For example, the first protective layer may improve durability and mechanical strength of the retardation layer by complementing the thickness of a thin O-plate type liquid crystal retardation layer. Alternatively, the first protective layer may be a base film for the O-plate type liquid crystal retardation layer. In addition, the first protective layer can prevent the retardation layer and/or the panel from being contaminated by iodine that can be eluted from the polarizer after the polarizing plate is left under high temperature/humidity conditions for a long period of time.

The first protective layer is an optically transparent film and may be a film formed of at least one resin selected from among, for example, cellulose ester resins including triacetylcellulose (TAC) and the like, polyester resins including polyethylene terephthalate (PET), polyethylene naphthalate, polybutylene naphthalate, and the like, cyclic polyolefin resins, polycarbonate resins, polyether sulfone resins, polysulfone resins, polyamide resins, polyimide resins, polyolefin resins, polyacrylate resins, polyvinyl alcohol resins, polyvinyl chloride resins, and polyvinylidene chloride resins.

In one embodiment, the first protective layer may have a front in-plane retardation of 10 nm or less, for example, 0 nm, 1 nm, 2 nm, 3 nm, 4 nm, 5 nm, 6 nm, 7 nm, 8 nm, 9 nm, 10 nm, or 0 nm to 5 nm, at a wavelength of 550 nm. Within this range, the first protective layer can secure inherent effects thereof without affecting the effects of the O-plate type liquid crystal retardation layer serving to reduce reflectivity on the front and lateral sides of the polarizing plate.

The first protective layer may have a thickness of 5 μm to 100 μm, for example, 15 μm to 45 μm. Within this range, the first protective layer can be used in the polarizing plate.

By way of example, the retardation layer may be formed by coating the composition comprising the liquid crystal compound on the first protective layer, followed by drying and curing the composition. Here, an alignment layer may be formed on a surface of the first protective layer, on which the composition is coated for alignment of the liquid crystal compound. The alignment layer may be formed by a typical method known to those skilled in the art. For example, the alignment layer may be an acryl-based alignment layer. A laminate of the O-plate type liquid crystal layer and the first protective layer may be coupled to the polarizer.

In another embodiment, the retardation layer may be formed by coating the composition comprising the liquid crystal compound on a base film, followed by drying and curing the composition. Here, an alignment layer may be formed on a surface of the base film, on which the composition is coated for alignment of the liquid crystal compound. The alignment layer may be formed by a typical method known to those skilled in the art. For example, the alignment layer may be an acrylic alignment layer. A laminate of the O-plate type liquid crystal layer and the base film may be coupled to the polarizer.

An adhesive layer or a bonding layer may be stacked on a lower surface of the retardation layer so that the polarizing plate can be adhesively attached to the panel therethrough.

The polarizing plate may further include a second protective layer described below on an upper surface of the polarizer. The second protective layer may be stacked singularly or in plural on the upper surface of the polarizer.

## Second protective layer

The second protective layer serves to protect the polarizer from external environments while improving

mechanical strength of the polarizing plate. The second protective layer may include a protective film and/or a protective coating layer.

The second protective layer may be an optically transparent film formed of at least one selected from among, for example, cellulose resins including triacetylcellulose (TAC) and the like, polyester resins including polyethylene terephthalate (PET), polybutylene terephthalate, polyethylene naphthalate (PEN), polybutylene naphthalate, and the like, cyclic olefin polymer (COP) resins, cyclic olefin copolymer (COC) resins, polycarbonate resins, polyether sulfone resins, polysulfone resins, polyamide resins, polyimide resins, polyolefin resins, polyarylate resins, polyvinyl alcohol resins, polyvinyl chloride resins, and polyvinylidene chloride resins.

The second protective layer may have a front retardation of 0 nm or more, for example, 0 nm to 10,000 nm, at a wavelength of 550 nm. Within this range, the effects of the present invention can be more easily realized

The polarizing plate may further include a functional coating layer on at least one surface of the second protective layer. For example, the functional coating layer may include an antireflection layer, a low reflectivity layer, a hard coating layer, an anti-fingerprint layer, an anti-glare layer, a primer layer, and the like.

The second protective layer may have a thickness of 5 μm to 100 μm, specifically 15 μm to 90 μm. Within this range, the second protective layer can be used in the polarizing plate.

The polarizing plate may further include a third protective layer described below on the lower surface of the polarizer. The third protective layer may be stacked singularly or in plural on the lower surface of the polarizer. In one embodiment, the third protective layer may be interposed between the polarizer and the retardation layer or may be disposed on the lower surface of the retardation layer.

**Third protective layer**

The third protective layer may be an optically transparent film formed of at least one selected from among, for example, cellulose resins including triacetylcellulose (TAC) and the like, polyester resins including polyethylene terephthalate (PET), polybutylene terephthalate, polyethylene naphthalate (PEN), polybutylene naphthalate, and the like, cyclic polyolefin resins, polycarbonate resins, polyether sulfone resins, polysulfone resins, polyamide resins, polyimide resins, polyolefin resins, polyarylate resins, polyvinyl alcohol resins, polyvinyl chloride resins, and polyvinylidene chloride resins.

In one embodiment, the third protective layer may have a front retardation of 10 nm or more, for example, 0 nm to 5 nm, at a wavelength of 550 nm. Within this range, the third protective layer can secure inherent effects thereof without affecting the effects of the O-plate type liquid crystal retardation layer serving to reduce reflectivity on the front and lateral sides of the polarizing plate.

The third protective layer may have a thickness of 5 μm to 100 μm, specifically 15 μm to 45 μm. Within this range, the third protective layer can be used in the polarizing plate.

The material, retardation and/or thickness of the third protective layer may be the same as or different than the first protective layer.

FIG. 4 to FIG. 9 are sectional views of a polarizing plate according to one embodiment of the present invention.

The polarizing plate may include a polarizer 30, an O-plate type liquid crystal retardation layer 10 stacked on a lower surface of the polarizer 30, and a second protective layer 20 stacked on an upper surface of the polarizer 30.

Alternatively, the polarizing plate may include: a polarizer 30; a first protective layer 40 and an O-plate type liquid crystal retardation layer 10 stacked in the stated order on the lower surface of the polarizer 30; and a second protective layer 20 stacked on the upper surface of the polarizer 30.

Alternatively, the polarizing plate may include: a polarizer 30; an O-plate type liquid crystal retardation layer 10 and a first protective layer 40 stacked in the stated order on the lower surface of the polarizer 30; and a second protective layer 20 stacked on the upper surface of the polarizer 30.

Alternatively, the polarizing plate may include: a polarizer 30; a third protective layer 50 and an O-plate type liquid crystal retardation layer 10 stacked in the stated order on the lower surface of the polarizer 30; and a second protective layer 20 stacked on the upper surface of the polarizer 30.

Alternatively, the polarizing plate may include: a polarizer 30; a third protective layer 50, an O-plate type liquid crystal retardation layer 10 and a first protective layer 40 stacked in the stated order on the lower surface of the polarizer 30; and a second protective layer 20 stacked on the upper surface of the polarizer 30.

Alternatively, the polarizing plate may include: a polarizer 30; a third protective layer 50, a first protective layer 40 and an O-plate type liquid crystal retardation layer 10 stacked in the stated order on the lower surface of the polarizer 30; and a second protective layer 20 stacked on the upper surface of the polarizer 30

Although not shown in FIG. 4 to FIG. 9, assuming that one surface of the O-plate type liquid crystal retardation layer in the thickness direction thereof is a TOP surface and the other surface thereof opposite the TOP surface is a BOTTOM surface, and has a greater liquid crystal tilt angle on the TOP surface than on the BOTTOM surface, the TOP surface of the O-plate type liquid crystal retardation layer is placed closer to the polarizer than the BOTTOM surface

thereof, or the BOTTOM surface of the O-plate type liquid crystal retardation layer is placed closer to the polarizer than the TOP surface thereof.

Although not shown in FIG. 4 to FIG. 9, an optical display panel may be stacked on a lower surface of the polarizing plate via an adhesive layer or a bonding layer to form an optical display apparatus.

The optical display apparatus according to the present invention includes a polarizing plate according to embodiments of the present invention. The optical display apparatus may include a light emitting diode display such as an organic light emitting diode (OLED) display, and a liquid crystal display.

In one embodiment, the organic light emitting diode display may include an organic light emitting diode panel including a flexible substrate, and the polarizing plate according to the present invention stacked on the organic light emitting diode panel. In another embodiment, the organic light emitting diode display may include an organic light emitting diode panel including a non-flexible substrate, and the polarizing plate according to the present invention stacked on the organic light emitting diode panel.

[Mode for Invention]

Next, the present invention will be described in more detail with reference to some examples. However, it should be noted that these examples are provided for illustration only and are not to be construed in any way as limiting the present invention.

## Example 1

A polarizer having a light transmittance of 45% was prepared by stretching a polyvinyl alcohol film (TS#20, thickness: 20 μm, Nippon Kuraray Co., Ltd.) to 6 times an initial thickness thereof in an aqueous iodine solution at 55°C.

An acrylic alignment film (HSPA-239, Nissan Chemical Co., Ltd.) was formed on a base film. An O-plate type retardation layer was formed by coating a composition for a nematic liquid crystal layer (RMM-2126, Merck) to a predetermined thickness on the acrylic alignment layer, followed by curing the composition at a predetermined temperature and air volume. The O-plate type retardation layer was removed from the base film. The O-plate type retardation layer was bonded to a lower surface of the prepared polarizer via a bonding layer and a TAC film (KC2UAW, KONICA, front retardation @ 550 nm: 3 nm) was bonded to an upper surface of the polarizer via a bonding layer, thereby preparing a polarizing plate of the TAC film - bonding layer - polarizer - bonding layer - O-plate type liquid crystal retardation layer.

The O-plate type retardation layer has negative wavelength dispersion. The TOP surface of the O-plate type retardation layer was placed closer to the polarizer than the BOTTOM surface and the slow axis of the O-plate type retardation layer was tilted at an angle of 45° with reference to the light transmittance axis of the polarizer. Details of the polarizing plate and the O-plate type liquid crystal retardation layer are shown in Table 1.

## Examples 2 to 4

Polarizing plates were prepared in the same manner as in Example 1 except that the temperature and the air volume for curing the composition were changed upon formation of the O-plate type liquid crystal retardation layer.

## Comparative Examples 1 to 4

Polarizing plates were prepared in the same manner as in Example 1 except that the temperature and the air volume for curing the composition were changed upon formation of the O-plate type liquid crystal retardation layer.

Retardation values of each of the retardation layer and the protective layer were measured at a wavelength of 550 nm using a retardation meter (AxoScan).

The polarizing plates of Examples and Comparative Examples were evaluated as to the following properties and evaluation results are shown in Table 1.

(1) Front in-plane retardation and oblique retardation 1 of O-plate type liquid crystal retardation layer (unit: nm, @550 nm): Front in-plane retardation of each of the retardation layers prepared in Examples and Comparative Examples was measured using an AxoScan by transmitting light through the retardation layer in the normal direction to an in-plane direction of the retardation layer. Oblique retardation 1 of each of the retardation layers prepared in Examples and Comparative Examples was measured using an AxoScan by transmitting light through the retardation layer while rotating the retardation layer at ±60° about the fast axis of the retardation layer.

(2) Oblique retardation 2 of O-plate type liquid crystal retardation layer (unit: nm, @550 nm): Oblique retardation 2 of each of the retardation layers prepared in Examples and Comparative Examples was measured using an AxoScan by transmitting light through the retardation layer while rotating the retardation layer at ±60° about the slow axis of the retardation layer.

(3) Reflectivity at front side and lateral side: For each of the polarizing plates prepared in Examples and Comparative Examples, reflectivity in a direction providing the maximum reflectivity was calculated by measuring reflectivity with respect to external light excluding primary reflection in all directions through a simulation program (Techwiz 1D, Sanai System Co., Ltd., Korea).

Table 1

| | | Example | | | | Comparative Example | | | |
|---|---|---|---|---|---|---|---|---|---|
| | | 1 | 2 | 3 | 4 | 1 | 2 | 3 | 4 |
| Liquid crystal tilt angle (°) | TOP | 55 | 50 | 70 | 80 | 75 | 0 | 25 | 90 |
| | BOTTOM | 0 | 0 | 0 | 0 | 0 | 0 | 0 | 0 |
| Wavelength dispersion | | Negative | Negative | Negative | Negative | Negative | Negative | Negative | Negative |
| Front retardation (nm) | | 140 | 140 | 140 | 140 | 140 | 140 | 140 | 140 |
| Oblique retardation 1 (nm) | Max | 208.6 | 239.4 | 184.8 | 183.4 | 343 | 116.2 | 137.2 | 270.2 |
| | Min | 60.2 | 43.4 | 77 | 86.8 | 37.8 | 116.2 | 98 | 68.6 |
| Ratio of Eq. 1 | Max | 1.49 | 1.71 | 1.32 | 1.31 | 2.45 | 0.83 | 0.98 | 1.93 |
| | Min | 0.43 | 0.31 | 0.55 | 0.62 | 0.27 | 0.83 | 0.7 | 0.49 |
| Oblique retardation 2 (nm) | | 182 | 197.4 | 170.8 | 163.8 | 228.2 | 169.4 | 169.4 | 179.2 |
| Reflectivity | Front | 0.59% | 0.59% | 0.59% | 0.59% | 0.59% | 0.59% | 0.59% | 0.59% |
| | Lateral | 2.43% | 3.06% | 2.66% | 2.71% | 19.81% | 8.52% | 7.49% | 7.88% |
| Difference in reflectivity | | 1.84% | 2.47% | 2.07% | 2.12% | 19.22% | 7.93% | 6.9% | 7.29% |
| *Negative: Negative wavelength dispersion<br>*Difference in reflectivity: Lateral reflectivity - Front reflectivity | | | | | | | | | |

As shown in Table 1, even with a single sheet type retardation layer, the polarizing plates according to the present invention secured screen uniformity by providing excellent effects in reduction of reflectivity at front and lateral sides thereof and in reduction of difference in reflectivity therebetween.

Conversely, the polarizing plates of Comparative Examples failing to satisfy the maximum ratio and the minimum ratio of Equation 1 according to the present invention could not provide the effects of the present invention.

For each of the retardation layers used in Examples, front in-plane retardation and oblique retardation were measured at a wavelength of 550 nm using an AxoScan while changing the rotational axis of the retardation meter. Here, the fast axis or slow axis of the retardation layer was set as a rotational axis. A relative value (ratio) of oblique retardation to front retardation was calculated and calculation results are shown in Tables 2 and 3 and FIG. 3.

[Table 2]

| Rotational angle | | -85° | -80° | -75° | -70° | -65° | -60° | -55° | -50° | -45° |
|---|---|---|---|---|---|---|---|---|---|---|
| Relative value according to rotational axis (ratio) | Fast axis | 1.35 | 1.35 | 1.34 | 1.33 | 1.32 | 1.31 | 1.29 | 1.27 | 1.25 |
| | Slow axis | 2.56 | 1.62 | 1.37 | 1.27 | 1.21 | 1.17 | 1.14 | 1.11 | 1.09 |

[Table 3]

| Rotational angle | | -40° | -35° | -30° | -25° | -20° | -15° | -10° | -5° | 0° |
|---|---|---|---|---|---|---|---|---|---|---|
| Relative value according to rotational axis (ratio) | Fast axis | 1.23 | 1.21 | 1.18 | 1.16 | 1.13 | 1.10 | 1.07 | 1.03 | 1.00 |
| | Slow axis | 1.07 | 1.05 | 1.04 | 1.03 | 1.02 | 1.00 | 1.00 | 1.00 | 1.00 |

[Table 4]

| Rotational angle | | 85° | 80° | 75° | 70° | 65° | 60° | 55° | 50° | 45° |
|---|---|---|---|---|---|---|---|---|---|---|
| Relative value according to rotational axis (ratio) | Fast axis | 0.56 | 0.57 | 0.58 | 0.59 | 0.60 | 0.62 | 0.64 | 0.66 | 0.69 |
| | Slow axis | 2.56 | 1.62 | 1.38 | 1.27 | 1.21 | 1.17 | 1.14 | 1.11 | 1.09 |

[Table 5]

| Rotational angle | | 40° | 35° | 30° | 25° | 20° | 15° | 10° | 5° | 0° |
|---|---|---|---|---|---|---|---|---|---|---|
| Relative value according to rotational axis (ratio) | Fast axis | 0.72 | 0.75 | 0.79 | 0.82 | 0.86 | 0.89 | 0.93 | 0.96 | 1.00 |
| | Slow axis | 1.07 | 1.05 | 1.04 | 1.03 | 1.02 | 1.01 | 1.00 | 1.00 | 1.00 |

As shown in FIG. 3, it could be seen that the retardation layer included in the polarizing plate of the present invention had an asymmetrical relative value according to the rotation angle about the fast axis as the rotation axis, and a symmetrical relative value according to the rotation angle about the slow axis as the rotation axis.

It should be understood that various modifications, changes, alterations, and equivalent embodiments can be made by those skilled in the art without departing from the spirit and scope of the invention.

## Claims

1. A polarizing plate comprising: a polarizer; and a retardation layer stacked on a lower surface of the polarizer,

   wherein the retardation layer has a maximum ratio of 1.1 to 1.8 and a minimum ratio of 0.3 to 0.7, as calculated according to Equation 1:

   [Equation 1]

   $$\text{Ratio} = B / A,$$

   (in the Equation 1,
   A is a front retardation of the retardation layer (unit: nm) at a wavelength of 550 nm; and
   B is an oblique retardation of the retardation layer (unit: nm), as measured at a wavelength of 550 nm with the retardation layer rotated at an angle of +60° or -60° about a fast axis of the retardation layer as a rotational axis).

2. The polarizing plate according to claim 1, wherein the retardation layer has an A value of 110 nm to 170 nm in Equation 1.

3. The polarizing plate according to claim 1, wherein the retardation layer has a maximum B value of 120 nm to 310 nm and a minimum B value of 20 nm to 120 nm in Equation 1.

4. The polarizing plate according to claim 1, wherein the retardation layer has a difference of 45 nm or more between the maximum oblique retardation and the minimum oblique retardation, as measured at a wavelength of 550 nm with the retardation layer rotated at an angle of +60° or -60° about the fast axis of the retardation layer as the rotational axis.

5. The polarizing plate according to claim 1, wherein the retardation layer has an oblique retardation of 130 nm to 240 nm, as measured at a wavelength of 550 nm with the retardation layer rotated at an angle of +60° or -60° about a slow axis of the retardation layer as the rotational axis.

6. The polarizing plate according to claim 1, wherein the retardation layer has negative wavelength dispersion.

7. The polarizing plate according to claim 1, wherein the retardation layer has an asymmetrical relative value in a graph where the x-axis denotes a rotational angle (°) of a retardation meter and the Y-axis denotes a relative value of oblique retardation (nm) to front retardation (nm) (oblique retardation/front retardation), the oblique retardation being measured with the fast axis of the retardation layer set as the rotational axis.

8. The polarizing plate according to claim 1, wherein the retardation layer has a symmetrical relative value in a graph where the x-axis denotes a rotational angle (°) of a retardation meter and the Y-axis denotes a relative value of oblique retardation (nm) to front retardation (nm) (oblique retardation/front retardation), the oblique retardation being measured with a slow axis of the retardation layer set as the rotational axis.

9. The polarizing plate according to claim 1, wherein a slow axis of the retardation layer is tilted at an angle of 40° to 50° with respect to a light transmission axis of the polarizer, assuming that the light transmission axis of the polarizer is set to 0°.

10. The polarizing plate according to claim 1, wherein the retardation layer comprises an O-plate type liquid crystal retardation layer.

11. The polarizing plate according to claim 10, wherein, assuming that one surface of the O-plate type liquid crystal retardation layer in a thickness direction thereof is a TOP surface and the other surface thereof opposite the top surface is a BOTTOM surface, the O-plate type liquid crystal retardation layer has a greater liquid crystal tilt angle on the TOP surface than on the BOTTOM surface.

12. The polarizing plate according to claim 11, wherein the O-plate type liquid crystal retardation layer has a liquid crystal tilt angle of 30° to 90° on the TOP surface and a liquid crystal tilt angle of 0° to 10° on the BOTTOM surface.

13. The polarizing plate according to claim 11, wherein the TOP surface is closer to the polarizer than the BOTTOM surface.

14. The polarizing plate according to claim 11, wherein an absolute difference between the liquid crystal tilt angle on the TOP surface and the liquid crystal tilt angle on the BOTTOM surface ranges from 30° to 90°.

15. The polarizing plate according to claim 10, wherein the O-plate type liquid crystal retardation layer is a nematic liquid crystal layer.

16. The polarizing plate according to claim 10, wherein the retardation layer comprises the O-plate type liquid crystal retardation layer alone.

17. The polarizing plate according to claim 10, wherein the retardation layer comprises the O-plate type liquid crystal retardation layer and a first protective layer.

18. The polarizing plate according to claim 17, wherein the first protective layer has a front retardation of 10 nm or less at a wavelength of 550 nm.

19. The polarizing plate according to claim 1, further comprising:
at least one of a second protective layer on an upper surface of the polarizer and a third protective layer on the lower surface of the polarizer.

20. An optical display apparatus comprising the polarizing plate according to any one of claims 1 to 19.

【FIG. 1】

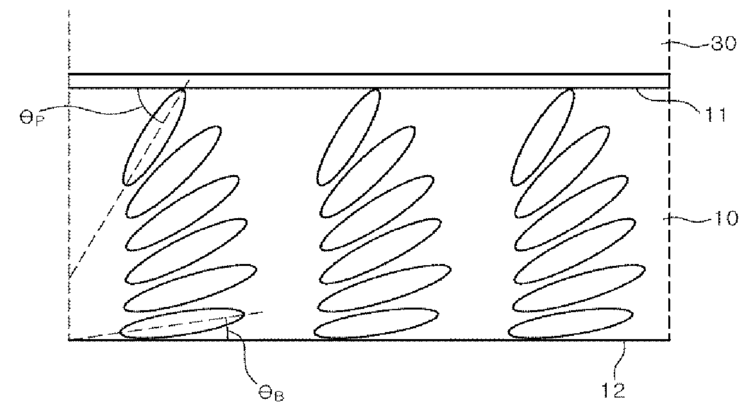

【FIG. 2】

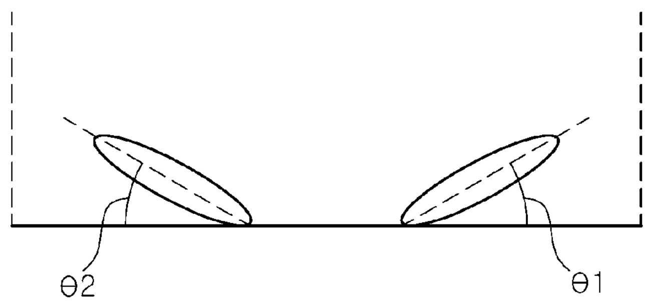

【FIG. 3】

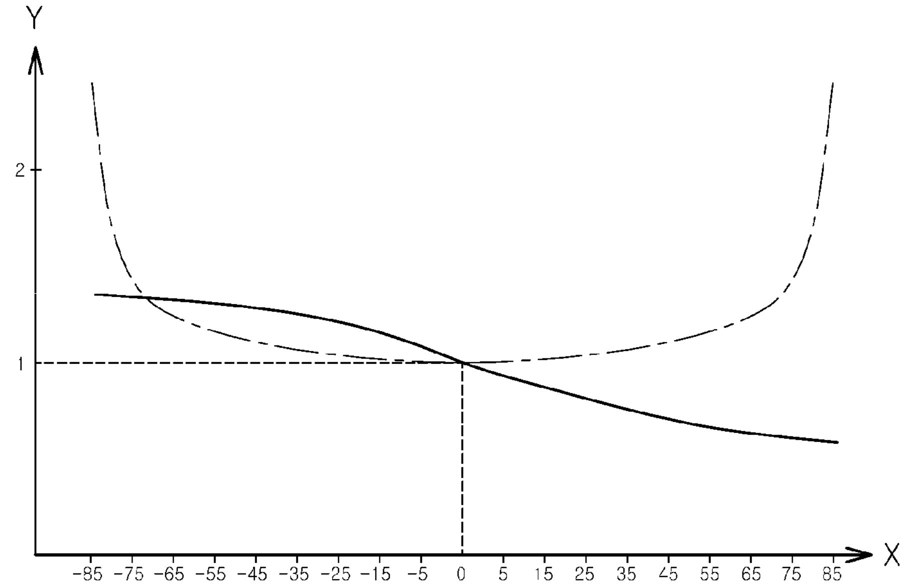

【FIG. 4】

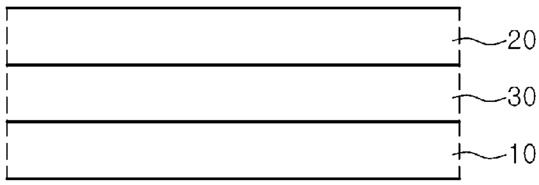

【FIG. 5】

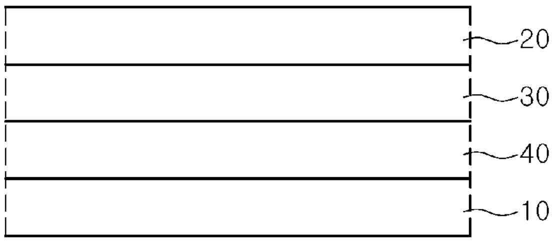

【FIG. 6】

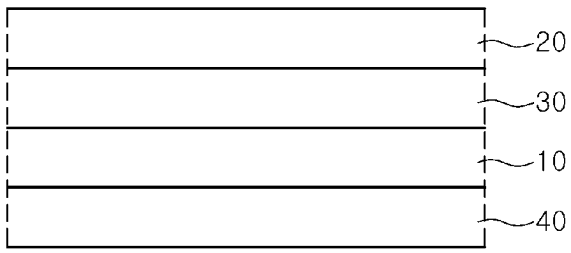

【FIG. 7】

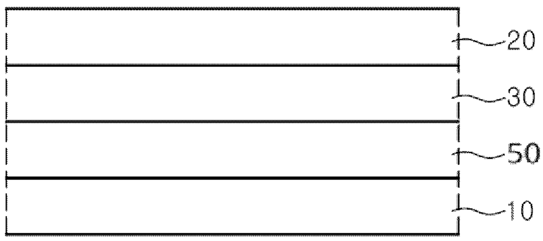

【FIG. 8】

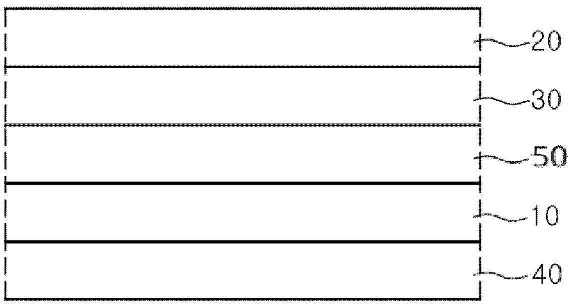

【FIG. 9】

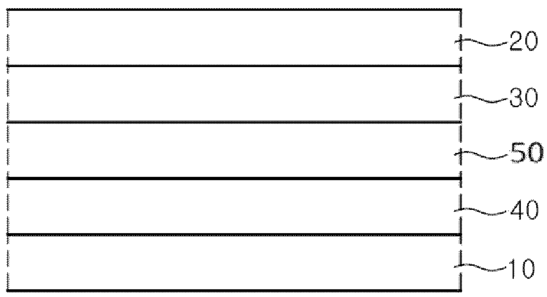

## INTERNATIONAL SEARCH REPORT

International application No.
**PCT/KR2023/020800**

**A. CLASSIFICATION OF SUBJECT MATTER**

**G02B 5/30**(2006.01)i; **H10K 59/50**(2023.01)i; **G02F 1/13363**(2006.01)i

According to International Patent Classification (IPC) or to both national classification and IPC

**B. FIELDS SEARCHED**

Minimum documentation searched (classification system followed by classification symbols)

G02B 5/30(2006.01); G02B 5/20(2006.01); G02F 1/1335(2006.01); G02F 1/13363(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 편광자(polarizer), 위상차(phase difference), 진상축(fast axis), 회전(rotation), 굴절률(refractive index)

**C. DOCUMENTS CONSIDERED TO BE RELEVANT**

| Category* | Citation of document, with indication, where appropriate, of the relevant passages | Relevant to claim No. |
|---|---|---|
| A | KR 10-2021-0087842 A (SAMSUNG SDI CO., LTD.) 13 July 2021 (2021-07-13)<br>See paragraph [0058] and figures 1-3. | 1-20 |
| A | KR 10-2021-0007465 A (LG CHEM, LTD.) 20 January 2021 (2021-01-20)<br>See paragraph [0022] and figures 1-3. | 1-20 |
| A | KR 10-2010-0058884 A (DONGWOO FINE-CHEM CO., LTD.) 04 June 2010 (2010-06-04)<br>See paragraph [0020] and figure 1. | 1-20 |
| A | KR 10-1361363 B1 (KONICA MINOLTA OPTO, INC.) 10 February 2014 (2014-02-10)<br>See paragraphs [0070]-[0075] and figures 1-2. | 1-20 |
| A | KR 10-2021-0019356 A (SAMSUNG SDI CO., LTD.) 22 February 2021 (2021-02-22)<br>See paragraphs [0057]-[0061] and figures 1-2. | 1-20 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **04 April 2024** | **04 April 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.
**PCT/KR2023/020800**

| Patent document cited in search report | | | Publication date (day/month/year) | Patent family member(s) | | | Publication date (day/month/year) |
|---|---|---|---|---|---|---|---|
| KR | 10-2021-0087842 | A | 13 July 2021 | KR | 10-2564216 | B1 | 04 August 2023 |
| KR | 10-2021-0007465 | A | 20 January 2021 | KR | 10-2590987 | B1 | 18 October 2023 |
| KR | 10-2010-0058884 | A | 04 June 2010 | | None | | |
| KR | 10-1361363 | B1 | 10 February 2014 | JP | 5169842 | B2 | 27 March 2013 |
| | | | | WO | 2008-099731 | A1 | 21 August 2008 |
| KR | 10-2021-0019356 | A | 22 February 2021 | CN | 114270231 | A | 01 April 2022 |
| | | | | KR | 10-2593638 | B1 | 24 October 2023 |
| | | | | US | 2022-0276424 | A1 | 01 September 2022 |
| | | | | WO | 2021-029626 | A1 | 18 February 2021 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020130103595